# EUROPEAN PATENT APPLICATION

(11) **EP 4 528 953 A1**
(43) Date of publication of application: **26.03.2025**
(21) Application number: 22942611.9
(22) Date of filing: 17.05.2022
(51) Int. Cl.: H02H 1/00, H02M 7/48

(54) **ELECTRONIC CONTROL DEVICE AND ELECTRONIC CONTROL METHOD**

(71) Applicant: MITSUBISHI ELECTRIC CORPORATION, Chiyoda-ku Tokyo 100-8310 (JP)
(72) Inventor: UEDA, Keitaro, Tokyo 100-8310 (JP); UNEME, Yutaka, Tokyo 100-8310 (JP); ARAKI, Rei, Tokyo 100-8310 (JP); ONO, Shuhei, Tokyo 100-8310 (JP)
(74) Representative: Hoffmann Eitle
(86) International application number: PCT/JP2022/020470
(87) International publication number: WO 2023/223406

(57) **Abstract**

An electronic control device comprises a reverse connection protection relay, a voltage detector, and a control device. The reverse connection protection relay comprises a switching element and a rectifying element. The switching element and the rectifying element are connected in parallel. A negative electrode of the rectifying element and a positive electrode of the rectifying element are connected to a negative electrode of a power source and a load, respectively, the load consuming power supplied from the power source. Opening and closing of the switching element are controlled on the basis of a switching control signal indicating presence or absence of power supply from the power source. The voltage detector is configured to detect a potential difference between both ends of the reverse connection protection relay. The control device is configured to determine a state of the reverse connection protection relay on the basis of the potential difference.

## Description

### [Technical Field]

The present disclosure relates to an electronic control device and an electronic control method.

### [Background Art]

Patent Document 1 describes an electronic control device including: a reverse connection protector including a MOSFET as a switching element and a Zener diode as a reverse flow prevention element; a power source circuit that generates a positive power source voltage; a voltage detector that detects a voltage between a positive power source voltage and a ground of a battery; an A/D convertor that performs A/D conversion on a voltage output from the voltage detector; and a failure diagnosis unit that performs failure diagnosis on the reverse connection protector on the basis of an output value output from the A/D convertor. Patent Document 1 describes providing an electronic control device capable of diagnosing a failure of a reverse connection protection element using a MOSFET as a reverse connection protection element between a load and a ground.

### [Citation List]

### [Patent Document]

[Patent Document 1]
Japanese Unexamined Patent Application, First Publication No. 2017-42015

### [Summary of Invention]

### [Technical Problem]

In the electronic control device described in Patent Document 1, when a positive voltage is applied from a positive electrode of a battery to a gate of the MOSFET, a drain and a source of the MOSFET are electrically connected. Therefore, a short-circuit failure in the MOSFET cannot be detected solely by monitoring a positive power source voltage. When the battery is reversely connected at the time of short-circuit failure, a current flows reversely. The reverse flow of the current causes a failure of the electronic control device. In order to avoid the reverse flow of the current, redundancy of a reverse connection protection relay or addition of a drive device for applying a positive power source voltage to a gate of the MOSFET is also conceivable. These measures require additional elements or peripheral circuits, thus leading to an increase in circuit scale or cost.

One object of the present disclosure is to provide an electronic control device and an electronic control method that solve the above-described problems.

### [Solution to Problem]

A first aspect is an electronic control device comprising a reverse connection protection relay, a voltage detector, and a control device, in which the reverse connection protection relay comprises a switching element and a rectifying element, the switching element and the rectifying element are connected in parallel, a negative electrode of the rectifying element and a positive electrode of the rectifying element are connected to a negative electrode of a power source and a load, respectively, the load is configured to consume power supplied from the power source, opening and closing of the switching element are controlled on the basis of a switching control signal indicating presence or absence of power supply from the power source, the voltage detector is configured to detect a potential difference between both ends of the reverse connection protection relay, and the control device is configured to determine a state of the reverse connection protection relay on the basis of the potential difference.

A second aspect is an electronic control method in an electronic control device comprising a reverse connection protection relay, a voltage detector, and a control device, in which the reverse connection protection relay comprises a switching element and a rectifying element, the switching element and the rectifying element are connected in parallel, a negative electrode of the rectifying element and a positive electrode of the rectifying element, the negative electrode of the rectifying element and the positive electrode of the rectifying element, are connected to a negative electrode of a power source and a load, respectively, the load is configured to consume power supplied from the power source, and opening and closing of the switching element are controlled on the basis of a switching control signal indicating presence or absence of power supply from the power source, the method including: a first step of detecting, by the voltage detector, a potential difference between both ends of the reverse connection protection relay; and second step of determining, by the control device, a state of the reverse connection protection relay on the basis of the potential difference.

### [Advantageous Effects of Invention]

According to the present disclosure, it is possible to economically detect a failure of a reverse connection protection relay.

### [Brief Description of Drawings]

FIG. 1 is a circuit diagram illustrating a configuration example of an electronic control device according to a first embodiment.
FIG. 2 is a circuit diagram illustrating a circuit configuration example around a reverse connection protection relay according to the first embodiment.
FIG. 3 is an explanatory diagram for describing a specific example of a method for determining a state of the reverse connection protection relay according to the first embodiment.
FIG. 4 is a circuit diagram illustrating a configuration example of an electronic control device according to a second embodiment.
FIG. 5 is an explanatory diagram for describing a specific example of a method for detecting a short-circuit failure in a reverse connection protection relay according to the second embodiment.

### [Description of Embodiments]

Hereinafter, embodiments will be described with reference to the drawings. Elements common to or corresponding to the drawings are denoted by the same reference numerals, and description thereof is applied unless otherwise specified.

### <First Embodiment>

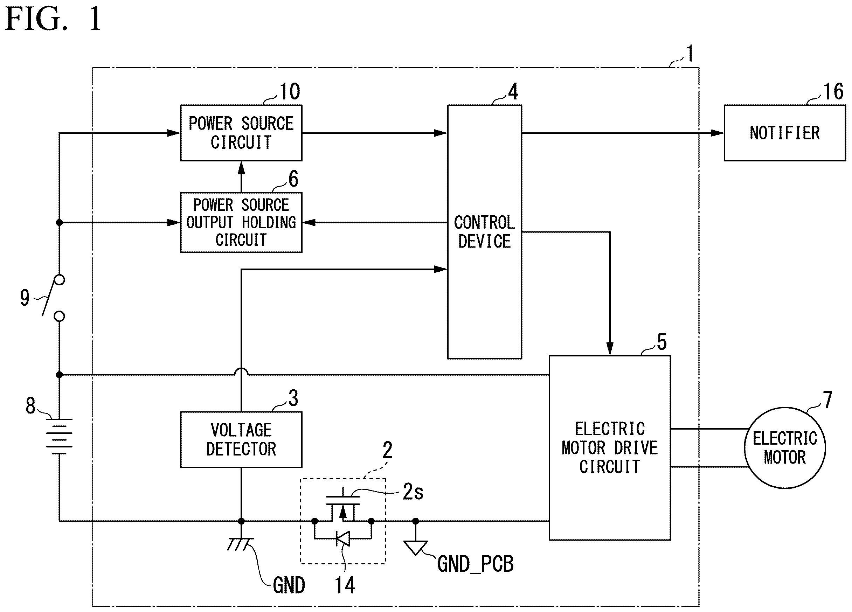

A first embodiment will be described with reference to the drawings. FIG. 1 is a circuit diagram illustrating a configuration example of an electronic control device 1 according to the present embodiment. In the example of FIG. 1, it is assumed that the electronic control device 1 is mounted on the same vehicle (not illustrated) together with a power source 8, a power source switch 9, and an electric motor 7, and is used to control an operation of an operation mechanism of the vehicle. The power source switch 9 controls necessity of power supply from the power source 8 to the electronic control device 1. The power source switch 9 receives an operation from a user, for example, and generates a switching control signal indicating the necessity of power supply according to the received operation. The power source switch 9 switches the necessity of power supply from the power source 8 to the electronic control device 1 according to the generated switching control signal, and outputs the generated switching control signal to the electronic control device 1. The necessity of power supply from the power source 8 to the electronic control device 1 is instructed using the switching control signal provided from the power source switch 9.

A battery and an ignition switch can be applied as the power source 8 and the power source switch 9, respectively. The battery is a storage battery capable of supplying DC power to the electronic control device 1. A driver of the vehicle can be a main user of the electronic control device 1. The ignition switch generates an ignition signal as an example of the switching control signal. The ignition signal is used to control activation (ON) or stop (OFF) of an operation mechanism of the vehicle. The operation mechanism of the vehicle includes, for example, electric power steering (EPS). The electric motor 7 forms a part of the operation mechanism.

The electronic control device 1 includes an electric motor drive circuit 5 as a load that consumes power supplied from the power source 8. The electric motor drive circuit 5 supplies power from the power source 8 to the electric motor 7 to drive the electric motor 7. The electric motor 7 also functions as a load that consumes power supplied from the power source 8. The number of electric motors 7 included in the operation mechanism of the vehicle is not limited to one, and can be two or more. In this case, the electric motor drive circuit 5 supplies power required for an operation of each electric motor 7. Note that, in the following description, a case where the number of electric motors 7 is one will be mainly described.

The electronic control device 1, the power source 8, the power source switch 9, and the electric motor 7 may be individually manufactured or transferred. In addition, the electronic control device 1, the power source 8, the power source switch 9, and the electric motor 7 may be attached to and detached from the vehicle at the time of maintenance, inspection, repair, or the like. For example, a positive electrode terminal and a negative electrode terminal of a battery as the power source 8 are connected to the electronic control device 1 using a power source plug (not illustrated). When the battery is replaced, the battery, which is a DC power source, may be connected to the power source plug in error of polarity. Connection with a polarity different from a predetermined polarity is called reverse connection. When the battery is connected with a wrong polarity, a current from the battery flows reversely in the electronic control device 1. The reverse flow of the current may cause a fault or a failure of the electronic control device 1. For protection from reverse connection, the electronic control device 1 includes a reverse connection protection relay 2. As described below, the electronic control device 1 can autonomously determine a state of the reverse connection protection relay 2.

The electronic control device 1 includes the reverse connection protection relay 2, a voltage detector 3, a control device 4, the electric motor drive circuit 5, a power source output holding circuit 6, and a power source circuit 10.

The reverse connection protection relay 2 protects the electric motor drive circuit 5 from a reverse flow of a current that may occur at the time of reverse connection of the power source 8. The reverse connection protection relay 2 includes a switching element 2s and a rectifying element 14. The switching element 2s and the rectifying element 14 are connected in parallel. That is, at one end of the reverse connection protection relay 2, one end of the rectifying element 14 and one end of the switching element 2s are electrically connected. At the other end of the reverse connection protection relay 2, the other end of the rectifying element 14 and the other end of the switching element 2s are electrically connected. The one end of the reverse connection protection relay 2 is connected to a negative electrode of the power source 8.

Opening and closing of both ends of the switching element 2s are controlled on the basis of a switching control signal applied from the power source switch 9 to the switching element 2s. Whether or not a current flows from one end to the other end of the switching element 2s is controlled in conjunction with presence or absence of power supply from the power source 8 to the electronic control device 1 indicated by the switching control signal. Even if the power source 8 is connected with a polarity reverse to the illustrated polarity, the reverse connection protection relay 2 cuts off a current from the power source 8 to the electric motor drive circuit 5. Therefore, the electric motor drive circuit 5 is protected from the reverse flow of the current.

A digital electric signal indicating necessity of power supply from the power source 8 depending on whether a voltage is a high voltage or a low voltage may be used as the switching control signal. The high voltage and the low voltage indicate a higher voltage and a lower voltage of two-stage voltages, respectively. When a signal with a high voltage is not supplied, a detected voltage may be a low voltage. In the present application, the high voltage may be referred to as High. The low voltage may be referred to as Low.

The switching element 2s is, for example, a metal-oxide-semiconductor field-effect transistor (MOSFET). The MOSFET generally comprises a source, a drain, and a gate. The MOSFET comprises a source terminal, a drain terminal, and a gate terminal in a source region, a drain region, and a gate region, respectively. The MOSFET as the switching element 2s is connected to the rectifying element 14 with its source terminal and drain terminal as one end and the other end, respectively. The switching control signal input from the power source switch 9 is applied to the gate terminal.

Note that the MOSFET as the switching element 2s may be any type of MOSFET such as an n-type MOSFET or a p-type MOSFET. The present embodiment exemplifies a case where an n-type MOSFET is used as the switching element 2s. In the n-type MOSFET, a silicon oxide film and a gate electrode are disposed in a gate region set on a p-type semiconductor substrate. In each of a drain region and a source region, an n-type semiconductor is disposed on the p-type semiconductor substrate. The n-type semiconductor is formed by ion implantation with impurity concentration higher than the p-type semiconductor.

The rectifying element 14 causes a current to flow from one end thereof to the other end of the rectifying element 14, and cuts off a current from the other end to the one end. The rectifying element 14 is, for example, a diode. The diode generally includes an anode and a cathode. The diode as the rectifying element 14 is connected to the switching element 2s with the anode and the cathode as one end thereof and the other end of the rectifying element 14.

For example, a parasitic diode may be used as the rectifying element 14. The parasitic diode is also referred to as a body diode. The parasitic diode is configured to have a pn junction between a source region and a drain region of the n-type MOSFET. The pn junction is formed by disposing a p-type semiconductor together with an n-type semiconductor in a source region and disposing an n-type semiconductor in a drain region such that the n-type semiconductor is not in contact with the p-type semiconductor. As the rectifying element 14, a parasitic diode configured in a MOSFET as the switching element 2s may be used. As a result, a MOSFET in which the switching element 2s and the rectifying element 14 are integrally configured can be used as the reverse connection protection relay 2.

The voltage detector 3 detects a voltage at one end of the reverse connection protection relay 2. As described later, a voltage detected on the basis of a reference potential GND_PCB corresponds to a potential difference between both ends of the reverse connection protection relay 2. The voltage detector 3 generates an electric signal indicating the detected voltage, and outputs the generated electric signal to the control device 4 as a detection voltage signal.

The control device 4 consumes power supplied from the power source 8 via the power source switch 9 and the power source circuit 10, and executes and controls various processes for exerting functions of the electronic control device 1. The control device 4 includes, for example, a central processing unit (CPU). The control device 4 determines a state of the reverse connection protection relay 2 on the basis of the detection voltage signal input from the voltage detector 3. The control device 4 includes, for example, an analog to digital (A/D) converter. The A/D converter converts the input analog detection voltage signal into a digital detection voltage signal, and determines a state of the reverse connection protection relay 2 on the basis of a voltage value indicated by the converted detection power signal. As the state of the reverse connection protection relay 2, for example, presence or absence of an open failure and/or presence or absence of a short-circuit failure is detected. A specific example of a method for determining the state of the reverse connection protection relay 2 will be described later.

The control device 4 may acquire a notification signal for providing a notification of the determined state and output the acquired notification signal to a notifier 16. The notifier 16 provides a notification of the state of the reverse connection protection relay 2 on the basis of the notification signal input from the control device 4. The notifier 16 may be a member that can present information to a user, for example, a light emitting diode or a speaker. When a light emitting diode and a speaker are used as the notifier 16, DC power and an acoustic signal are used, respectively. The light emitting diode emits light according to DC power supplied from the control device 4. The speaker emits sound on the basis of an acoustic signal input from the control device 4. As the notifier 16, for example, a warning lamp, an audio speaker, or the like disposed in front of a driver's seat of the vehicle may be applied. The notifier 16 may be integrated with the electronic control device 1 or may be configured separately.

The control device 4 controls an operation of the electric motor drive circuit 5 on the basis of a known control method. The control device 4 controls the electric motor drive circuit 5 on the basis of, for example, an ignition signal input to the control device 4. The control device 4 causes the electric motor drive circuit 5 to operate the electric motor 7 when a voltage of the ignition signal is High. At this time, the control device 4 generates a drive control signal for instructing the operation of the electric motor 7, and outputs the generated drive control signal to the electric motor drive circuit 5. When the voltage of the ignition signal is Low, the control device 4 causes the electric motor drive circuit 5 to stop the operation of the electric motor 7. At this time, the control device 4 stops outputting the drive control signal to the electric motor drive circuit 5.

Various signals are input to the control device 4 from devices included in the vehicle as vehicle-side input signals. The vehicle-side input signals include a torque signal from a torque sensor that detects a steering operation, a vehicle speed signal from a vehicle speed sensor, and the like. The control device 4 may execute an arithmetic process and a drive instruction for driving an operation mechanism of the vehicle using the vehicle-side input signals.

The electric motor drive circuit 5 drives the electric motor 7 under control of the control device 4. As a power supply state, for example, necessity of power supply to the electric motor 7 is instructed. When a drive control signal indicating that an operation of the electric motor 7 is necessary is input from the control device 4 to the electric motor drive circuit 5, the electric motor drive circuit 5 supplies power from the power source 8 to the electric motor 7. When the drive control signal is not input from the control device 4 to the electric motor drive circuit 5, the electric motor drive circuit 5 stops power supply from the power source 8 to the electric motor 7. The electric motor drive circuit 5 includes, for example, a bridge circuit and a motor relay switching element. The bridge circuit includes a high-side switching element and a low-side switching element for supplying power to each of one or more coils included in the electric motor 7. The motor relay switching element cuts off power supplied to the electric motor 7 when the drive control signal indicates that the operation is not necessary.

When a switching control signal is input from the power source switch 9 to the power source output holding circuit 6 or when a power request signal is input from the control device 4 to the power source output holding circuit 6, the power source output holding circuit 6 outputs an operation permission signal to the power source circuit 10. The power request signal is an electric signal for indicating that power supply is necessary. The power request signal indicates that power supply is necessary with a voltage being High. The operation permission signal is an electric signal for instructing holding of an operating voltage of the control device 4. The operation permission signal indicates holding of the operating voltage with a voltage being High. The control device 4 outputs the power request signal to the power source output holding circuit 6 during the operation.

The power source output holding circuit 6 has, for example, a diode OR configuration. The power source output holding circuit 6 includes, for example, two diodes and one resistance element, and one end of each of the diodes serves as an input end of the power source output holding circuit 6. The other end of each of the diodes is connected to one end of the resistance element and serves as an output end of the power source output holding circuit 6. The other end of the resistance element is grounded.

According to this configuration, when a voltage of the switching control signal input from power source switch 9 changes from High to Low, the power source circuit 10 can hold an operating voltage of the control device 4. Note that each of the power source output holding circuit 6 and the power source circuit 10 may comprise a storage battery that stores power supplied from the power source 8. Even if power from the power source 8 is interrupted, an output of the operation permission signal from the power source output holding circuit 6 is maintained. At this time, power is supplied from the storage battery of the power source circuit 10 to the control device 4. Thus, power supply from the power source 8 via the power source circuit 10 is prevented from being immediately cut off during the operation of the control device 4. Therefore, opportunities for termination of the operation of the electric motor drive circuit 5 by the control device 4, a finalization of the control device 4 itself, and the like can be ensured. The finalization comprises, for example, a process of writing internal data of the control device 4 at that time into a memory included in the control device 4. Immediately after the voltage of the switching control signal changes from High to Low, the control device 4 can terminate the operation at a predetermined timing without immediately terminating the operation.

After completion of the finalization, the control device 4 terminates outputting the power request signal to the power source output holding circuit 6. When an input of the switching control signal from the power source switch 9 and an input of the power request signal from the control device 4 are terminated, the power source output holding circuit 6 terminates outputting the operation permission signal to the power source circuit 10. When no power is supplied from the power source 8 via the power source switch 9 and no operation permission signal is input from the power source output holding circuit 6, the power source circuit 10 terminates holding the operating voltage. At this time, power supply from the power source circuit 10 to the control device 4 is terminated.

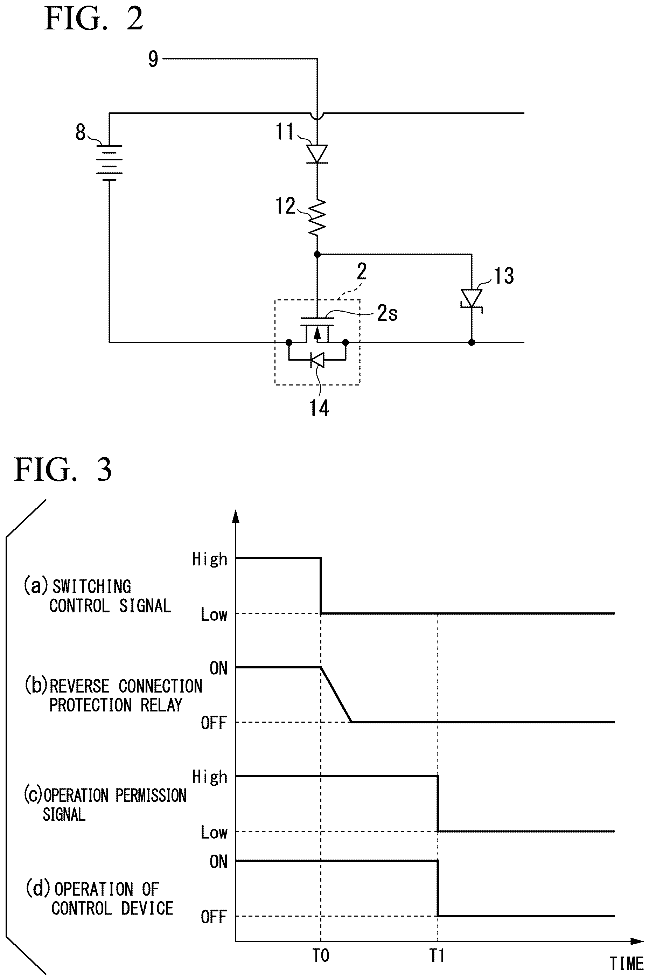

Next, a circuit configuration example around the reverse connection protection relay 2 according to the present embodiment will be described. FIG. 2 is a circuit diagram illustrating a circuit configuration example around the reverse connection protection relay 2 according to the present embodiment. In the example of FIG. 2, a case where the switching element 2s is a MOSFET, and a parasitic diode formed in the MOSFET is applied as the rectifying element 14 is illustrated. The reverse connection protection relay 2 is configured to include one MOSFET. A gate terminal of the MOSFET as the switching element 2s is connected to the power source switch 9 via a resistance element 12 and a rectifying element 11. An anode and a cathode of a Zener diode 13 are connected to a gate terminal and a source terminal of the MOSFET, respectively. A switching control signal supplied from the power source switch 9 is applied to the gate terminal of the MOSFET. The rectifying element 11 is a charge holding diode for holding a charge when a voltage of the switching control signal is Low. The resistance element 12 is a current limiting resistor for preventing an excessive current. The Zener diode 13 is provided to avoid a reverse flow of a current due to the switching control signal, thereby protecting the electric motor drive circuit 5l.

According to the configuration of FIG. 2, the source terminal and the drain terminal of the MOSFET as the switching element 2s are electrically connected (ON) while a voltage of the switching control signal is High. The source terminal of the MOSFET is cut off from the drain terminal (OFF) while the voltage of the switching control signal is Low. Note that, in the example of FIG. 2, the rectifying element 11, the resistance element 12, and the Zener diode 13 are not essential. Some or all of the rectifying element 11, the resistance element 12, and the Zener diode 13 may be omitted, or may be replaced with other members.

Next, a specific example of a method for determining a state of the reverse connection protection relay 2 will be described. FIG. 3 is an explanatory diagram for describing a specific example of the method for determining a state of the reverse connection protection relay 2 according to the present embodiment. First, a specific example of a method for detecting an open failure as a state of the reverse connection protection relay 2 will be described. The open failure of the reverse connection protection relay 2 refers to a failure in which connection between both ends of the switching element 2s is cut off (OFF) when both ends of the switching element 2s should be electrically connected (ON). In the following description, it is assumed that power is initially supplied from the power source 8 to the power source circuit 10 via the power source switch 9, the control device 4 operates, and the electric motor drive circuit 5 does not operate.

FIG. 3 illustrates time courses of the switching control signal, a state of the reverse connection protection relay, the operation permission signal, and an operation state of the control device. In the illustrated example, a voltage of the switching control signal supplied from the power source switch 9 is initially High. When no open failure occurs, both ends of the reverse connection protection relay 2 are electrically connected (ON). Thus, a current from a positive electrode terminal to a negative electrode terminal of the power source 8 passes through the switching element 2s. When an open failure occurs, connection between both ends of the reverse connection protection relay 2 is cut off (OFF). Therefore, a current from a positive electrode terminal to a negative electrode terminal of the power source 8 passes through the rectifying element 14 connected in parallel with the switching element 2s. Accordingly, a potential difference generated between both ends of the reverse connection protection relay 2 is different between the case where a current passes through the switching element 2s and the case where the current passes through the rectifying element 14.

As an example, it is assumed that a resistance between a drain and a source of the MOSFET as the switching element 2s is 1 mΩ, a forward voltage Vf of the parasitic diode as the rectifying element 14 is 700 mV, and power consumption of the electronic control device 1 is 1 A. When a current passes through the MOSFET, the potential difference is 1 mV. When a current passes through the parasitic diode, the potential difference corresponds to 700 mV, which is a forward voltage of the parasitic diode. The forward voltage depends on characteristics of each rectifying element 14, but has a value sufficiently larger than the potential difference when a current passes through the switching element 2s. A reference potential may be preset such that a voltage corresponding to this potential difference can be detected by the voltage detector 3.

As illustrated in FIG. 1, a reference potential GND of the voltage detector 3 is set so as to be equal to a potential of a negative electrode of the power source 8. A reference potential GND_PCB of a control component including the power source circuit 10 and the control device 4 is set so as to be equal to a potential between the reverse connection protection relay 2 and the electric motor drive circuit 5. A position where the reference potential GND is set and a position where the reference potential GND_PCB is set are separated across both ends of the reverse connection protection relay 2.

As described above, a potential difference generated between the reference potential GND and the reference potential GND_PCB is significantly different between the case where an open failure occurs in the reverse connection protection relay 2 and the case where the open failure does not occur in the reverse connection protection relay 2. Therefore, the control device 4 determines presence or absence of an open failure of the switching element 2s on the basis of a detection voltage signal input from the voltage detector 3. A voltage based on the reference potential GND_PCB is a potential difference between both ends of the reverse connection protection relay 2. More specifically, the control device 4 compares a voltage indicated by the detection voltage signal with a preset open failure threshold, and can determine presence or absence of an open failure by whether or not the voltage indicated by the detection voltage signal is higher than the open failure threshold. The open failure threshold may be preset between a voltage (potential difference) detected in case of an open failure and a voltage (potential difference) detected not in case of the open failure.

Note that, when the electric motor 7 is driven in a state where an open failure occurs in the reverse connection protection relay 2, a drive current passes through the rectifying element 14. Power consumption of the rectifying element 14 corresponds to a product of a potential difference between both ends of the rectifying element 14 and the drive current. The power consumption is larger than power consumption of the switching element 2s when the drive current passes through the switching element 2s. An increase in calorific value may cause abnormal heat generation, leading to failure, smoking, or ignition. Therefore, the control device 4 may determine presence or absence of an open failure of the reverse connection protection relay 2 before the operation of the electric motor drive circuit 5 starts. When determining occurrence of an open failure, the control device 4 does not have to output a drive control signal to the electric motor drive circuit 5 regardless of whether or not an ignition signal is input. Thus, abnormal heat generation due to current flow to the rectifying element 14 can be avoided without operating the electric motor drive circuit 5.

Next, a specific example of a method for detecting a short-circuit failure in the reverse connection protection relay 2 will be described. The short-circuit failure in the reverse connection protection relay 2 refers to a failure in which both ends of the switching element 2s are electrically connected (ON) when connection between both ends of the switching element 2s should be cut off (OFF). In the following description, as illustrated in FIG. 3, it is assumed that a voltage of a switching control signal from the power source switch 9 changes from High to Low at time T0. At this time, a voltage of an operation permission signal output from the power source output holding circuit 6 is maintained at High. Therefore, even when the time passes T0, the operation of the control device 4 continues. The control device 4 terminates the operation of the electric motor drive circuit 5 and performs a finalization of the control device 4. Thereafter, at time T1, the control device 4 terminates the operation. At this time, the voltage of the operation permission signal output from the power source output holding circuit 6 changes from High to Low. The control device 4 can ensure an opportunity to execute failure detection of the reverse connection protection relay 2 in an output holding period from time T0 to time T1.

Since the voltage of the control signal is Low in the output holding period, connection between both ends of the switching element 2s is cut off (OFF) unless a short-circuit failure occurs. Therefore, a current from a positive electrode terminal to a negative electrode terminal of the power source 8 passes through the rectifying element 14. On the other hand, when a short-circuit failure occurs, the current from the positive electrode terminal to the negative electrode terminal of the power source 8 passes through the switching element 2s. As described above, a potential difference between both ends of the reverse connection protection relay 2 varies depending on whether the current passes through the rectifying element 14 or passes through the switching element 2s.

As an example, it is assumed that a resistance between a drain and a source of the MOSFET as the switching element 2s is 1 mΩ, a forward voltage Vf of the parasitic diode as the rectifying element 14 is 700 mV, and power consumption of the electronic control device 1 is 1 A. When a current passes through the MOSFET, the potential difference is 1 mV. When a current passes through the parasitic diode, the potential difference corresponds to 700 mV, which is a forward voltage of the parasitic diode.

Thus, the control device 4 may determine presence or absence of a short-circuit failure in the switching element 2s on the basis of a detection voltage signal input from the voltage detector 3. The detection voltage signal indicates a voltage detected by the voltage detector 3. More specifically, the control device 4 compares a voltage indicated by the detection voltage signal with a preset short-circuit failure threshold, to determine presence or absence of a short-circuit failure based on whether or not the voltage indicated by the detection voltage signal is lower than the short-circuit failure threshold. The short-circuit failure threshold may be preset a value between a voltage (potential difference) detected in case of short-circuit failure and a voltage (potential difference) detected not in case of the short-circuit failure. In addition, as described above, the reference potential GND of the voltage detector 3 may be preset so as to be equal to a potential of the negative electrode of the power source 8. In addition, a reference potential GND_PCB of a control component including the power source circuit 10 and the control device 4 is set so as to be equal to a potential between the reverse connection protection relay 2 and the electric motor drive circuit 5. With this setting, a voltage indicated by the detection voltage signal corresponds to a potential difference between both ends of the reverse connection protection relay 2.

When determining a short-circuit failure, the control device 4 supplies DC power to a warning lamp mounted on the vehicle, for example, as a notification signal for providing a notification of the short-circuit failure. The warning lamp emits light according to DC power from the control device 4. A driver who has visually recognized the light-emitting warning lamp is notified of occurrence of the short-circuit failure. When an ignition switch is applied as an example of the power source switch 9, protection from a current by battery connection as the power source 8 is provided during an ignition OFF period. The ignition OFF period corresponds to a duration when an ignition signal with a High voltage is not input. Generally, the battery is not replaced while the vehicle is traveling. Therefore, it can be practically sufficient that a short-circuit failure is detected during the ignition OFF period.

Note that the above description exemplifies a case where the reverse connection protection relay 2 is driven on the basis of a switching control signal from the power source switch 9 in place of power supplied from the power source 8, and an operating voltage of the control device 4 is held using the power source output holding circuit 6. When power is not supplied from the power source 8, even if electrical connection between both ends of the reverse connection protection relay is cut off using the switching control signal, the operating voltage of the control device 4 is maintained by the power source output holding circuit 6. Even in such a case, the control device 4 can autonomously detect a short-circuit failure in the reverse connection protection relay 2.

### <Second Embodiment>

A second embodiment will be described with reference to the drawings. The following description will mainly focus on a difference from the first embodiment. Unless otherwise specified, the description in the first embodiment is applied to other matters. An electronic control device 1 according to the present embodiment can detect presence or absence of a short-circuit failure as a state of a reverse connection protection relay 2 even in a case where power supply from a power source 8 is started in addition to a case where the power supply from the power source 8 is cut off. Thereafter, opening and closing of the reverse connection protection relay 2 are controlled on the basis of a switching control signal.

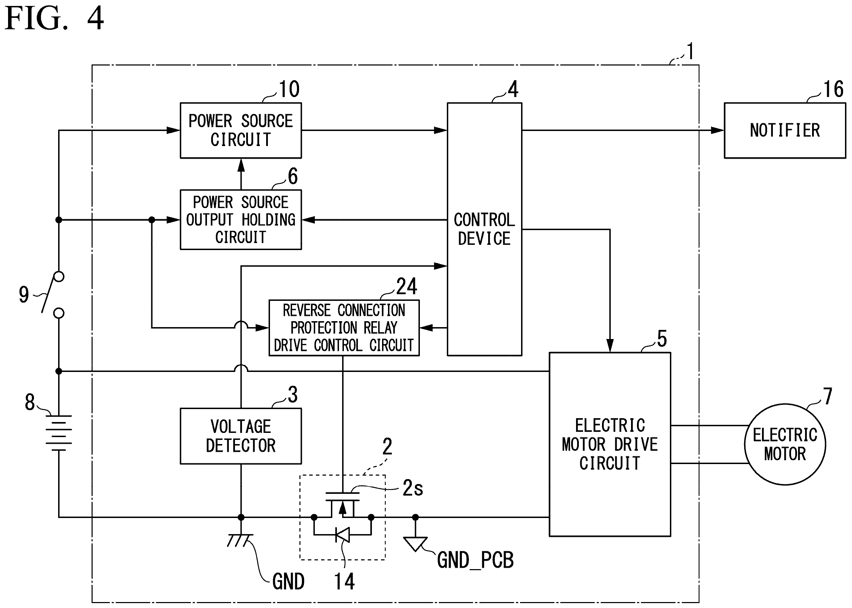

FIG. 4 is a circuit diagram illustrating a configuration example of the electronic control device 1 according to the present embodiment.

The electronic control device 1 according to the present embodiment includes a reverse connection protection relay drive control circuit 24 in addition to the reverse connection protection relay 2, a voltage detector 3, a control device 4, an electric motor drive circuit 5, a power source output holding circuit 6, and a power source circuit 10. The reverse connection protection relay drive control circuit 24 is disposed between and connected to a power source switch 9 and the reverse connection protection relay 2. When receiving, as an input, a switching control signal indicating power supply on from the power source switch 9 and a switching command signal indicating a switching command for the reverse connection protection relay 2 from the control device 4, the reverse connection protection relay drive control circuit 24 outputs the switching control signal indicating power supply on to the reverse connection protection relay 2. When receiving a switching control signal indicating power supply off from the power source switch 9, or when not receiving a switching command signal indicating a switching command for the reverse connection protection relay 2 from the control device 4, the reverse connection protection relay drive control circuit 24 outputs the switching control signal indicating power supply off to the reverse connection protection relay 2. Necessity of the switching command is indicated by, for example, whether a voltage of the switching command signal is High or Low.

Therefore, when the switching command is acquired from the control device 4, the reverse connection protection relay drive control circuit 24 can control opening and closing of the reverse connection protection relay 2 according to the switching control signal from the power source switch 9. When the switching command is not acquired, the reverse connection protection relay drive control circuit 24 cuts off connection between both ends of the reverse connection protection relay 2 regardless of whether or not a switching control signal having a High voltage is input. In this state, the control device 4 can determine presence or absence of a short-circuit failure in the reverse connection protection relay 2 on the basis of a voltage indicated by a detection power signal input from the voltage detector 3. After determining presence or absence of a short-circuit failure, the control device 4 outputs a switching command signal indicating a switching command for the reverse connection protection relay 2 to the reverse connection protection relay drive control circuit 24. The switching command is represented, for example, with a voltage of the switching command signal being High. The control device 4 includes, for example, a general purpose input/output (GPIO) port, and can output the switching command signal using the GPIO.

Note that the control device 4 executes an initialization process when power supply from the power source circuit 10 is started. The initialization process includes, for example, processes such as reading of internal data stored in a memory and detection of various devices connected to the control device 4. After completing the initialization process, the control device 4 can determine presence or absence of a short-circuit failure. After determining that there is no short-circuit failure, the control device 4 outputs a switching command signal to the reverse connection protection relay drive control circuit 24. As a result, opening and closing of the reverse connection protection relay 2 based on the switching control signal from the power source switch 9 can be controlled. At this stage, the control device 4 may start control of the electric motor drive circuit 5 based on an ignition signal.

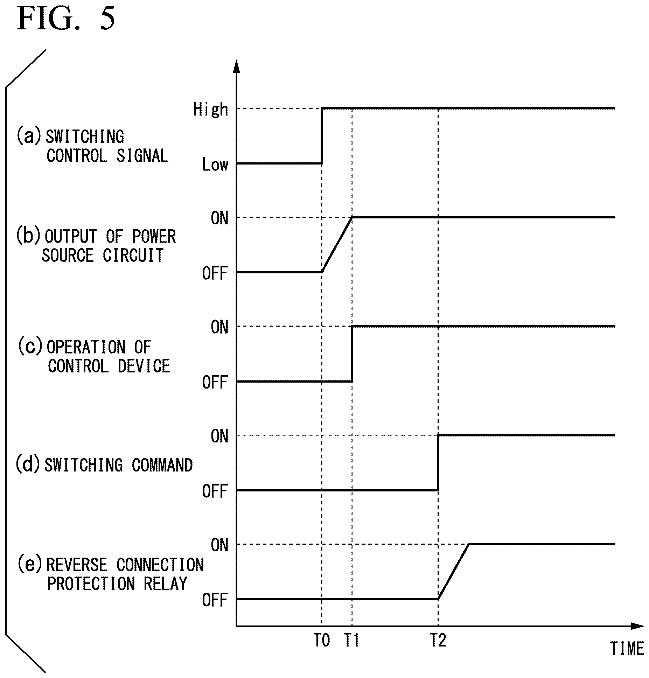

Next, a specific example of a method for detecting a short-circuit failure in the reverse connection protection relay 2 will be described. FIG. 5 is an explanatory diagram for describing an example of a method for detecting a short-circuit failure in the reverse connection protection relay 2 according to the present embodiment. In the following description, it is assumed that power is not initially supplied from the power source 8 to the power source circuit 10 via the power source switch 9, and both the control device 4 and the electric motor drive circuit 5 do not operate. FIG. 5 illustrates time courses of the switching control signal, an output of the power source circuit, an operation state of the control device 4, the switching command, and a state of the reverse connection protection relay 2. In the illustrated example, a voltage of the switching control signal supplied from the power source switch 9 is initially Low. When a short-circuit failure does not occur, electrical connection between both ends of the reverse connection protection relay 2 is cut off (OFF). In this state, power is not supplied from the power source 8 to the power source circuit 10 via the power source switch 9. Therefore, a voltage of power supplied from the power source circuit 10 to the control device 4 is 0 V (OFF). At this time, since the control device 4 does not operate (OFF), the switching command signal is not output from the control device 4 (OFF).

Next, it is assumed that the voltage of the switching control signal from the power source switch 9 changes from Low to High at time T0. At this time, a voltage of power supplied from the power source circuit 10 to the control device 4 starts to rise from 0 V (OFF) and reaches a operating voltage (ON) at time T1, the operating voltage preset in the control device 4. At this time, the voltage is stabilized, and an initialization process is started as an operation of the control device 4 (ON). After the initialization process is ended, at time T2, the control device 4 starts outputting a switching command signal indicating a switching command to the reverse connection protection relay drive control circuit 24 (ON). At this time, the reverse connection protection relay drive control circuit 24 starts outputting a switching control signal having a High voltage to the reverse connection protection relay 2. If no short-circuit failure occurs, both ends of the reverse connection protection relay 2 begin to change from a cut-off state (OFF) to an electrically connected state (ON). Therefore, the control device 4 can determine presence or absence of a short-circuit failure in the reverse connection protection relay 2 on the basis of a voltage value indicated by a detection power signal input from the voltage detector 3 during a period until the switching command signal is output at time T2 after the initialization process is ended.

In this period, since the power source circuit 10 and the control device 4 operate, a current is generated from a positive electrode terminal to a negative electrode terminal of the power source 8. When no short-circuit failure occurs in the reverse connection protection relay 2, connection between both ends of the switching element 2s should be cut off (OFF). In this state, the generated current passes through the rectifying element 14 connected in parallel with the switching element 2s. When a short-circuit failure occurs, both ends of the switching element 2s are electrically connected (ON). Therefore, a current from a positive electrode terminal to a negative electrode terminal of the power source 8 passes through the switching element 2s. Therefore, a potential difference generated between both ends of the reverse connection protection relay 2 is different between the case where a current passes through the rectifying element 14 and the case where the current passes through the switching element 2s.

As an example, it is assumed that a resistance between a drain and a source of the MOSFET as the switching element 2s is 1 mΩ, a forward voltage Vf of the parasitic diode as the rectifying element 14 is 700 mV, and power consumption of the electronic control device 1 is 1 A. When a current passes through the parasitic diode, the potential difference corresponds to 700 mV, which is a forward voltage of the parasitic diode. When a current passes through the MOSFET, the potential difference is 1 mV.

Therefore, the control device 4 determines presence or absence of a short-circuit failure in the switching element 2s on the basis of a detection voltage signal input from the voltage detector 3. More specifically, the control device 4 compares a voltage indicated by the detection voltage signal with a preset short-circuit failure threshold, and can determine presence or absence of a short-circuit failure by whether or not the voltage indicated by the detection voltage signal is lower than the short-circuit failure threshold. The short-circuit failure threshold may be preset between a voltage in case of a short-circuit failures and a voltage not in case of the short-circuit failure.

Accordingly, the reverse connection protection relay drive control circuit 24 can control the electrical connection between both ends of the reverse connection protection relay 2 to be cut off, even when power is supplied from the power source 8. Therefore, the control device 4 can determine presence or absence of a short-circuit failure in the reverse connection protection relay 2 even after power supplied from the power source 8 is consumed and the operation is started.

Next, a modification of the electronic control devices 1 according to the above embodiments will be described. The electronic control device 1 may include, for example, any one of the power source switch 9, the electric motor 7, and the notifier 16, or a combination of any of these, and may be integrally configured. The electronic control device 1 may further include the power source 8. The electronic control device 1 may have a function of controlling another device mounted on the vehicle. The other device may be, for example, any one of an acoustic device, an air conditioning device, a navigation device, a driving assistance system, and the like, or a combination of any of these. The electronic control device 1 may be configured as an electronic control unit (ECU).

The power source 8 is not limited to a portable power source such as a battery, and may be a stationary power source. Power supply from the power source 8 to the electronic control device 1 is not limited to wired power supply, and may be wireless power supply. When a wireless charger is used as the power source 8, the electronic control device 1 may include a wireless power receiver and receive power transmitted from the wireless charger. The load is not limited to the electric motor drive circuit 5, and may be another device as long as the device consumes power supplied from the power source 8. The device serving as the load does not have to be configured integrally with the electronic control device 1.

The switching element 2s is not necessarily limited to a MOSFET, and may be another type of bipolar transistor. The rectifying element 14 is not necessarily limited to a diode, and may be a selenium rectifier or the like.

A display may be used as the notifier 16. The control device 4 may generate a signal representing information indicating a determined state by characters, symbols, or images as the above notification signal, and output the signal to the display. When a speaker is used as the notifier 16, a signal representing the information indicating the determined state by voice may be generated as the above signal and output to the speaker. The notification information may include, in addition to the information indicating the determined state, information indicating a countermeasure (for example, component replacement or contact with a sales store) for the state.

As described above, the electronic control device 1 according to the present disclosure includes the reverse connection protection relay 2, the voltage detector 3, and the control device 4. The reverse connection protection relay 2 comprises the switching element 2s and the rectifying element 14, and the switching element 2s and the rectifying element 14 are connected in parallel. A negative electrode of the rectifying element 14 and a positive electrode of the rectifying element 14 are connected to a negative electrode of the power source 8 and a load (for example, the electric motor drive circuit 5), respectively. The load is configured to consume power supplied from the power source 8. Opening and closing of the switching element 2s are controlled on the basis of a switching control signal indicating presence or absence of power supply from the power source. The voltage detector 3 is configured to detect a potential difference between both ends of the reverse connection protection relay 2. The control device 4 is configured to determine a state of the reverse connection protection relay 2 on the basis of the detected potential difference.

In general, electrical resistance of the reverse connection protection relay 2 depends on a state of the reverse connection protection relay 2. According to this configuration, the state of the reverse connection protection relay 2 is determined on the basis of the potential difference generated between both ends of the reverse connection protection relay 2 by a current through the reverse connection protection relay 2 in response to power supply from the power source 8. Therefore, the state of the reverse connection protection relay 2 is autonomously detected without an increase in circuit scale or cost.
the control device 4 may detect presence or absence of an open failure as the state of the reverse connection protection relay 2 in case of power supply from the power source 8.

According to this configuration, when electrical connection of both ends of the reverse connection protection relay 2 is instructed, presence or absence of an open failure can be determined on the basis of the potential difference between both ends of the reverse connection protection relay 2.

The electronic control device 1 may include the power source circuit 10 and the power source output holding circuit 6. The power source circuit 10 may convert a power source voltage of power supplied from the power source 8 into an operating voltage of the control device 4. The power source output holding circuit 6 may cause the power source circuit 10 to hold the operating voltage in case of interruption of power supply from the power source 8. The control device 4 may detect presence or absence of a short-circuit failure as a state of the reverse connection protection relay 2.

According to this configuration, even when the power supply from the power source 8 is cut off, the operating voltage of the control device 4 is maintained. On the other hand, control is performed such that electrical connection between both ends of the reverse connection protection relay 2 is cut off. The control device 4 can determine presence or absence of a short-circuit failure on the basis of the potential difference between both ends of the reverse connection protection relay 2 without terminating the operation.

The electronic control device 1 may further comprise a drive control circuit (for example, the reverse connection protection relay drive control circuit 24). The drive control circuit may cause both ends of the switching element 2s to be electrically connected in case of power supply from the power source 8 and the switching command is acquired from the control device 4. The control device 4 may detect presence or absence of a short-circuit failure as a state of the reverse connection protection relay 2 before the power supply from the power source 8 and the switching command acquired from the control device 4.

According to this configuration, even when power is supplied from the power source 8, electrical connection between both ends of the switching element 2s is cut off at a stage where a switching command is not acquired from the control device 4. Even before a switching command is input, the control device 4 is operated by the power supply from the power source 8, whereby presence or absence of a short-circuit failure can be determined on the basis of a potential difference between both ends of the reverse connection protection relay 2.

A reference potential serving as a reference of the operating voltage of the control device 4 and a reference potential of the voltage detector 3 may be separated across both ends of the reverse connection protection relay 2.

According to this configuration, by setting the reference potential of the control device 4 to one end of the reverse connection protection relay 2, the voltage detector 3 can detect the voltage at the one end of the reverse connection protection relay 2 as a potential difference between both ends of the reverse connection protection relay 2.

The switching element 2s may be a MOSFET, and the rectifying element 14 may be a parasitic diode formed by joining a source and a drain of the MOSFET.

According to this configuration, one MOSFET is configured as the reverse connection protection relay 2. Reducing the number of components contributes to miniaturization and cost reduction of the electronic control device 1.

The load may be the electric motor drive circuit 5 that is configured to drive the electric motor 7. Opening and closing of the switching element 2s may be controlled on the basis of an ignition signal input from an ignition switch as the switching control signal.

According to this configuration, opening and closing of the switching element 2s can avoid a reverse flow of a current to the electric motor drive circuit 5 due to a reverse connection of the power source 8 in conjunction with power supply to the electric motor drive circuit 5 by the ignition switch. In addition, a state of the reverse connection protection relay 2 can be detected without delay by using the ignition signal in control of the switching element 2s.

Although the embodiments of the present disclosure have been described above, the present disclosure is not limited to these embodiments and a modification thereof. Addition, omission, replacement, and other changes of the configuration can be made without departing from the gist of the present disclosure.

A direction of an arrow illustrated in the block diagrams and other drawings are for convenience of description, and do not limit flow directions of information, data, signals, and the like in implementation.

In addition, the present disclosure is not limited by the above description, but is limited solely by the attached claims.

### [Industrial Applicability]

According to the electronic control device and the electronic control method according to the present disclosure, a state of the reverse connection protection relay 2 is determined on the basis of a potential difference generated between both ends of the reverse connection protection relay 2 by a current through the reverse connection protection relay 2 in response to power supply from the power source 8. Therefore, the state of the reverse connection protection relay 2 is autonomously detected without an increase in circuit scale or cost.

### [Reference Signs List]

1 Electronic control device
2 Reverse connection protection relay
2s Switching element
3 Voltage detector
4 Control device
5 Electric motor drive circuit
6 Power source output holding circuit
8 Power source
9 Power source switch
10 Power source circuit
11 Rectifying element
12 Resistance element
13 Zener diode
14 Rectifying element
24 Reverse connection protection relay drive control circuit

## Claims

1. An electronic control device comprising a reverse connection protection relay, a voltage detector, and a control device, wherein
the reverse connection protection relay comprises a switching element and a rectifying element,
the switching element and the rectifying element are connected in parallel,
a negative electrode of the rectifying element and a positive electrode of the rectifying element are connected to a negative electrode of a power source and a load, respectively,
the load is configured to consume power supplied from the power source, opening and closing of the switching element are controlled on a basis of a switching control signal indicating presence or absence of power supply from the power source,
the voltage detector is configured to detect a potential difference between both ends of the reverse connection protection relay, and
the control device is configured to determine a state of the reverse connection protection relay on a basis of the potential difference.

2. The electronic control device according to claim 1, wherein
the control device is configured to detect presence or absence of an open failure as the state of the reverse connection protection relay in case of power supply from the power source.

3. The electronic control device according to claim 1 or 2, comprising a power source circuit and a power source output holding circuit, wherein
the power source circuit is configured to convert a power source voltage of power supplied from the power source into an operating voltage of the control device, and
the power source output holding circuit is configured to cause the power source circuit to hold the operating voltage in case of interruption of power supply from the power source, and
the control device is configured to detect presence or absence of a short-circuit failure as the state of the reverse connection protection relay.

4. The electronic control device according to any one of claims 1 to 3, further comprising a drive control circuit, wherein
the drive control circuit is configured to cause both ends of the switching element to be electrically connected in case of power supply from the power source and a switching command acquired from the control device, and
the control device is configured to detect presence or absence of a short-circuit failure as the state of the reverse connection protection relay before the power supply from the power source and the switching command acquired from the control device.

5. The electronic control device according to any one of claims 1 to 4, wherein
a reference potential serving as a reference of an operating voltage of the control device and a reference potential of the voltage detector are separated across both ends of the reverse connection protection relay.

6. The electronic control device according to any one of claims 1 to 5, wherein
the switching element is a metal-oxide-semiconductor field-effect transistor (MOSFET), and
the rectifying element is a parasitic diode formed by joining a source and a drain of the MOSFET.

7. The electronic control device according to any one of claims 1 to 6, wherein
the load is an electric motor drive circuit that is configured to drive an electric motor, and
opening and closing of the switching element are controlled on a basis of an ignition signal input from an ignition switch as the switching control signal.

8. An electronic control method in an electronic control device comprising a reverse connection protection relay, a voltage detector, and a control device, wherein
the reverse connection protection relay comprises a switching element and a rectifying element,
the switching element and the rectifying element are connected in parallel,
a negative electrode of the rectifying element and a positive electrode of the rectifying element, the negative electrode of the rectifying element and the positive electrode of the rectifying element, are connected to a negative electrode of a power source and a load, respectively,
the load is configured to consume power supplied from the power source, and
opening and closing of the switching element are controlled on a basis of a switching control signal indicating presence or absence of power supply from the power source,
the method comprising:
a first step of detecting, by the voltage detector, a potential difference between both ends of the reverse connection protection relay; and
a second step of determining, by the control device, a state of the reverse connection protection relay on a basis of the potential difference.
